# EUROPÄISCHE PATENTSCHRIFT

(11) **EP 0 905 800 B1**
(45) Veröffentlichungstag und Bekanntmachung des Hinweises auf die Patenterteilung: **12.06.2002**
(21) Anmeldenummer: 98117386.7
(22) Anmeldetag: 14.09.1998
(51) Int. Cl.: H01L 39/14, H01L 39/24

(54) **Hoch-Tc-Ein- oder Mehrkernsupraleiter und Verfahren zu dessen Herstellung**
High Tc single or multifilament superconductor and method of manufacturing the same
Supraconducteur à haute Tc à filaments uniques ou muliples et procédé de fabrication

(30) Priorität: 25.09.1997 DE 19742364
(43) Veröffentlichungstag der Anmeldung: 31.03.1999
(73) Patentinhaber: SIEMENS AKTIENGESELLSCHAFT, 80333 München (DE)
(72) Erfinder: Eibl, Oliver, Dr., 81669 München (DE); Roas, Bernhard, Dr., 89520 Heidenheim (DE)
(74) Vertreter: Schmuckermaier, Bernhard

(56) Entgegenhaltungen:
- US-A- 4 954 479

## Beschreibung

Die Erfindung bezieht sich auf einen Supraleiter mit mindestens einem in ein normalleitendes, zumindest weitgehend silberfreies Matrixmaterial eingebetteten Leiterkern, welcher ein von einem oxidischen Material umhülltes Supraleitermaterial mit wenigstens einer supraleitenden Hoch-T_{c}-Phase auf Basis eines Bi-Cuprates enthält. Die Erfindung betrifft ferner ein Verfahren zur Herstellung eines solchen Supraleiters.

Ein entsprechender Supraleiter und ein Verfahren zu seiner Herstellung sind der *EP 0 308 326 A* zu entnehmen.

Es sind supraleitende Metalloxidverbindungen mit hohen Sprungtemperaturen T_{c} von über 77 K bekannt, die deshalb auch als Hoch-T_{c}-Supraleitermaterialien oder HTS-Materialien bezeichnet werden und eine Flüssig-Stickstoff (LN₂) -Kühltechnik erlauben. Unter solche Metalloxidverbindungen fallen insbesondere Cuprate von speziellen Stoffsystemen wie insbesondere der selten-erd-freien Basistypen Bi-Sr-Ca-Cu-O oder (Bi,Pb)-Sr-Ca-Cu-O. Ihre supraleitenden Hoch-T_{c}-Phasen unterscheiden sich durch die Anzahl der Kupfer-Sauerstoff-Netzebenen bzw. - Schichten innerhalb der kristallinen Einheitszelle und weisen verschiedene Sprungtemperaturen T_{c} auf.

Mit diesen bekannten HTS-Materialien wird versucht, langgestreckte Supraleiter in Draht- oder Bandform herzustellen. Ein hierfür als geeignet angesehenes Verfahren ist die sogenannte "Pulver-im-Rohr-Technik", die prinzipiell von der Herstellung von Supraleitern mit dem klassischen metallischen Supraleitermaterial Nb₃Sn her bekannt ist. Entsprechend dieser bekannten Technik wird auch zur Herstellung von Leitern aus HTS-Material in eine rohrförmige Umhüllung bzw. in eine Matrix aus einem normalleitenden Material wie z.B. aus Ag oder einer Ag-Legierung Pulver aus einem Vormaterial des HTS-Materials eingebracht, das im allgemeinen noch nicht oder nur zu einem geringen Anteil die gewünschte supraleitende Hoch-T_{c}-Phase enthält. Der so zu erhaltende Rohleiter wird anschließend mittels Verformungsbehandlungen, die gegebenenfalls durch mindestens eine Wärmebehandlung bei erhöhter Temperatur unterbrochen sein können, auf die gewünschte Enddimension gebracht. Danach wird das so erhaltene Leiterzwischenprodukt zur Einstellung oder Optimierung seiner supraleitenden Eigenschaften bzw. zur Ausbildung der gewünschten Hoch-T_{c}-Phase mindestens einer Glühbehandlung unterzogen. Diese Glühbehandlung wird wenigstens teilweise in einer sauerstoffhaltigen Atmosphäre bei einer erhöhten Temperatur durchgeführt, die für das Stoffsystem (Bi,Pb)-Sr-Ca-Cu-O an Luft im allgemeinen zwischen 835°C und 840°C und bei reduziertem Sauerstoff-Partialdruck bei etwa 815°C liegt (vgl. z.B. auch *"Supercond. Sci. Technol.", Vol. 4, 1991, Seiten 165 bis 171*).

Neben entsprechend hergestellten Einkernleitern mit einem Leiterkern aus dem HTS-Material und einer Umhüllung aus dem normalleitenden Material sind auch sogenannte Mehrkern- oder Multifilamentleiter mit HTS-Leiterkernen bekannt (vgl. *"IEEE Trans. Appl. Supercond.", Vol. 5, No. 2, Juni 1995, Seiten 1259 bis 1261*). Solche Mehrkernleiter werden in an sich bekannter Weise mittels einer Bündelungstechnik erhalten. Hierzu wird ein als ein Zwischenprodukt des herzustellenden Multifilamentsupraleiters anzusehender Rohleiter erstellt, indem eine vorbestimmte Anzahl einzelner Rohleiterelemente zu dem Bündel zusammengefaßt werden. Jedes einzelne Rohleiterelement besteht dabei aus einem Leiterkern und einer Umhüllung aus dem normalleitenden Material. Das Leiterkernmaterial kann schon das metalloxidische Supraleitermaterial mit der gewünschten Hoch-T_{c}-Phase sein oder ein Vormaterial im Hinblick auf dieses Supraleitermaterial darstellen, das noch nicht optimierte supraleitende Eigenschaften besitzt und beispielsweise das mindestens eine Ausgangsmaterial des auszubildenden Supraleitermaterials ist. Für AC-Anwendungen kann noch das Bündel von einzelnen Leiterkernen um die gemeinsame Leiterachse verdrillt (getwistet) werden.

Die bekannten Multifilamentsupraleiter mit HTS-Material haben bevorzugt eine Bandform. Um diese Form eines entsprechenden Leiterendproduktes zu erhalten, muß mindestens ein Walzschritt vorgesehen werden. Dabei wird im allgemeinen von einer zunächst zylinderförmigen Gestalt des Rohleiters ausgegangen, wobei eine Gleichverteilung der Leiterkerne über den Querschnitt gesehen vorgesehen wird. Dieser Aufbau wird dann mittels des Walzprozesses in die flache Bandform überführt, um so die für eine hohe Stromtragfähigkeit notwendige Textur, d.h. weitgehend parallele Ausrichtung der Kristallebenen der supraleitenden Phase, zu erreichen. Das Ergebnis ist dann ein Flachleiter mit einem Breiten-zu-Dicken-Verhältnis von beispielsweise 10 oder höher.

Es zeigt sich jedoch, daß bei einer derartigen Herstellung eines bandförmigen Multifilamentsupraleiters unter Verwendung von Ag als normalleitendem Material die Weiterverarbeitung des nach dem letzten querschnittsvermindernden Verformungsschrittes und der letzten Glühung vorliegenden Bandleiters aufgrund der verhältnismäßig geringen Festigkeitseigenschaften des Ag-Materials äußerst problematisch ist. Bei schon geringster Belastung des Bandleiters neigt nämlich die das keramische Supraleitermaterial umgebende Ag-Matrix zu einer inhomogenen plastischen Verformung. Dabei können die spröden Leiteradern aus dem keramischen Supraleitermaterial dieser Dehnung nicht folgen und brechen deshalb.

Eine an sich bekannte Verwendung von Ag-Legierungen als normalleitendes Matrixmaterial steigert zwar die Festigkeit des fertigen Supraleiters, welches sich somit besser weiterverarbeiten läßt. Es ist jedoch festzustellen, daß der Einsatz von rohrförmigen Hüllen aus Ag-Legierungen zur Herstellung der Leitervorprodukte gemäß der erwähnten Pulver-im-Rohr-Technik die Bildung der gewünschten Hoch-T_{c}-Phase des Supraleitermaterials derart beeinträchtigt, daß ein deutlicher Abfall der (kritischen) Stromtragfähigkeit zu beobachten ist. Außerdem muß der gesamte Herstellungsprozeß auf die Verwendung des Legierungsmaterials abgestimmt werden. Dies führt zu einer unerwünschten Erhöhung des zeitlichen und apparativen Aufwandes. Man will deshalb vielfach auf eine Verwendung von Ag-Legierungen verzichten. Ein solcher Wunsch besteht schon aus Kostengründen, da Ag oder Ag-haltiges Material ein kostenintensiver Werkstoff ist.

Als ein vergleichsweise kostengünstigerer Werkstoff ist Cu anzusehen. Gemäß der eingangs genannten EP-A-Schrift ist für den dort beschriebenen Einkernsupraleiter eine Umhüllung aus Cu oder Cu-Legierung vorgesehen, die an ihrer Innenseite eine Ag₂O-Beschichtung besitzt. Diese Beschichtung soll dadurch hergestellt werden, daß man an der Innenseite eines im Rahmen einer Pulver-im-Rohr-Technik verwendeten Cu-Rohres eine Ag₂Ohaltige Paste mit einem organischen Binder aufbringt. Dieser Binder wird bei einer anschließenden Glühung zersetzt. Eine solche Beschichtungstechnik ist verhältnismäßig schwer durchführbar und deshalb aufwendig.

Aufgabe der vorliegenden Erfindung ist es deshalb, einen Supraleiter mit den eingangs genannten Merkmalen bereitzustellen, der sich mit vermindertem Aufwand herstellen läßt. Insbesondere soll ein Leiterendprodukt hoher kritischer Stromdichte zu erhalten sein, das ohne die Gefahr einer Beschädigung seiner mindestens einen supraleitenden Leiterader zu supraleitenden Einrichtungen wie Kabeln oder Magnetwicklungen weiterverarbeitet werden kann.

Für den Supraleiter ist die Lösung dieser Aufgabe erfindungsgemäß darin zu sehen, daß als oxidisches Umhüllungsmaterial um den mindestens einen Leiterkern ZrO₂ oder ein mit Y teiloder vollstabilisiertes ZrO₂ vorgesehen ist.

Die mit dieser Ausgestaltung des Supraleiters verbunden Vorteile sind darin zu sehen, daß sich ein Leiterkern in verhältnismäßig einfacher Weise mit dem gegebenenfalls Y-stabilisierten ZrO₂-Material vorzugsweise in Folienform umhüllen läßt. Außerdem stellt eine derartige ZrO₂-Umhüllung eine Pufferschicht dar, der zweierlei Funktion zukommt: Zum einen unterbindet sie eine Diffusion der chemischen Elemente aus dem Leiterkernmaterial in das Metall des Hüllrohres; zum andern ist ZrO₂ ein Material mit einer großen Diffusionskonstante für Sauerstoff und mit dem Vermögen, als Sauerstoffreservoir für das supraleitende Material zu dienen.

Das Verfahren zur Herstellung eines entsprechenden Supraleiters ist folglich dadurch gekennzeichnet, daß ein Vorprodukt des Leiterkerns mit einer Umhüllung aus dem ZrO₂-Material erstellt wird, daß dann das umhüllte Vorprodukt in ein Rohr aus dem normalleitenden Material eingebracht wird und mindestens einer querschnittsvermindernden Verformungsbehandlung unterzogen wird und daß schließlich das so erhaltene Zwischenprodukt zu dem Endprodukt des Supraleiters weiterverarbeitet wird. Dabei- kann insbesondere aus dem Zwischenprodukt ein Bündel von einzelnen Leiterelementen erstellt werden, das dann in ein Hüllrohr aus dem normalleitenden Material eingebracht wird. Als Hüllrohrmaterial ist vorzugsweise Cu oder ein Cu-haltiges Material geeignet.

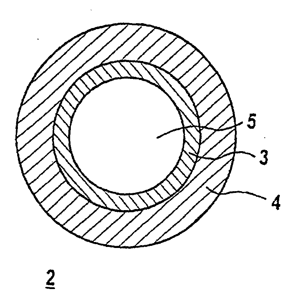

Vorteilhafte Ausgestaltungen des erfindungsgemäßen Supraleiters sowie des Verfahrens zu seiner Herstellung gehen aus den jeweils abhängigen Ansprüchen hervor.
Die Erfindung wird nachfolgend noch weiter erläutert, wobei auf die Zeichnung Bezug genommen wird. Dabei zeigt schematisch deren einzige Figur einen Querschnitt durch einen erfindungsgemäßen Supraleiter.

Ein erfindungsgemäßer Supraleiter stellt einen langgestreckten Verbundkörper in Band- oder Drahtform dar. Dieser Verbundkörper enthält ein normalleitendes, Ag zumindest weitgehend nicht-enthaltendes Matrixmaterial, in den ein oxidisches Hoch-T_{c}-Supraleitermaterial (HTS-Material) mit wenigstens einer supraleitenden Hoch-T_{c}-Phase eingebettet ist. Als HTS-Material ist ein selten-Erd-freies Bi-Cuprat vorgesehen, dessen Sprungtemperatur T_{c} über der Verdampfungstemperatur des flüssigen Stickstoffs liegt. Ein entsprechendes Beispiel ist das HTS-Material vom Grundtyp (Bi,Pb)₂Sr₂Ca₂Cu₃Oₓ, das auch als Bi-2223-Phase bezeichnet wird und nachfolgend als Ausführungsbeispiel angenommen ist. Zur Herstellung eines entsprechenden HTS-Leiters kann vorteilhaft die an sich bekannte Pulver-im-Rohr-Technik zugrunde gelegt werden (vgl. z.B. die DE 44 44 937 A). Hierzu wird ein pulverförmiges Ausgangsmaterial, das eine Ausbildung der gewünschten supraleitenden Phase ermöglicht, oder das supraleitende Material in ein Hüllrohr eingebracht, dessen Material als Matrixmaterial für das fertige Endprodukt des Supraleiters dient. Für das Hüllrohr soll insbesondere auch aus Kostengründen ein Ag-freies, elektrisch gut leitendes Material wie insbesondere Cu oder A1 oder ein Material gewählt werden, das eines dieser Elemente enthält. Das Material kann dabei in reiner Form mit einem einzigen Element wie Cu oder in Form einer Legierung mit dem Element als Hauptbestandteil (d.h. zu mehr als 50 Gew.-%) vorliegen. So ist z.B. reines Cu beispielsweise in Form von kaltverfestigtem Cu oder rekristallisiertem Cu verwendbar.

Auch kann pulvermetallurgisch hergestelltes Cu vorgesehen werden. Daneben ist auch z.B. mit MgO dispersionsgehärtetes Cu geeignet. Das Material kann gegebenenfalls auch Ag zu einem geringen Anteil (unter 20 Gew.-%) enthalten.

Da entsprechende Matrixmaterialien gegebenenfalls unerwünschte Reaktionen mit den Komponenten des HTS-Ausgangsmaterial eingehen könnten, ist eine als Pufferschicht dienende Zwischenschicht zwischen dem Ausgangsmaterial und dem Matrixmaterial vorgesehen. Diese Schicht soll aus einem ZrO₂-Material bestehen, das mit Y teilstabilisiert sein kann (sogenanntes "PSZ"; vgl. "Appl. Phys. Lett.", Vol. 59, No. 13, sept. 1991, Seiten 1638 bis 1640). Insbesondere kommt auch ein mit Y vollstabilisiertes ZrO₂-Material (sogenanntes "YSZ"; vgl. "Appl. Phys. Lett.", Vol. 57, No. 11, Sept. 1990, Seiten 1137 bis 1139) in Frage. Entsprechende ZrO₂-Materialien werden kommerziell insbesondere in Folienform vertrieben.

Dementsprechend wird das im allgemeinen pulverförmige HTS-Ausgangsmaterial der gewünschten Zusammensetzung vorzugsweise mit einer dünnen Folie aus dem ZrO₂-Material umwickelt oder in anderer, bekannter Weise mit einer entsprechenden dünnen Umhüllung aus dem ZrO₂-Material versehen. Die Ausgangsdicke der Folie (vor einem querschnittsvermindernden Verfahrensschritt) liegt dabei im allgemeinen in der für Puffer- oder Diffusionsbarrierenschichten üblichen Größenordnung von beispielsweise 1 bis 10 µm. Das so umhüllte HTS-Ausgangsmaterial wird dann z.B. kalt-isostatisch zu mindestens einem dünnen Stab gepreßt. Dieser Stab stellt ein mit der Umhüllung aus dem ZrO₂-Material versehenes Vorprodukt eines Leiterkerns des HTS-Leiterendproduktes dar. Anschließend wird das umhüllte Vorprodukt in ein Hüllrohr aus dem normalleitenden Matrixmaterial eingebracht.

Dieser Aufbau aus dem Hüllrohr und dem von ihm umschlossenen, mit der ZrO₂-Umhüllung versehenen Vorprodukt des HTS-Materials kann anschließend eine Abfolge von mehreren insbesondere querschnittsvermindernden Verformungsschritten und mindestens einer Wärme-(Glüh) behandlung zur Ausbildung der gewünschten supraleitenden Phase unterzogen werden. Für die Verformungsschritte kommen alle bekannten Verfahren wie z.B. Strangpressen, Rollen, Walzen, Hämmern und Ziehen in Frage, die auch miteinander kombiniert sein können. Diese mechanischen Behandlungen können sowohl bei Raumtemperatur als auch bei erhöhter Temperatur durchgeführt werden. Nach den Verformungsschritten liegt dann ein Verbundkörper mit einer dem angestrebten Endprodukt zumindest weitgehend entsprechenden Gestalt, beispielsweise in Bandform, vor. Dieser Verbundkörper weist jedoch noch nicht die gewünschten supraleitenden Eigenschaften auf. Deshalb erfolgt noch mindestens eine Wärmeoder Glühbehandlung, die vorzugsweise in einer sauerstoffhaltigen Atmosphäre wie z.B. an Luft durchgeführt wird, um so in dem Vorproduktmaterial in an sich bekannter Weise den für die Ausbildung der gewünschten supraleitenden Phase erforderlichen Sauerstoff über die Umgebung zur Verfügung zu stellen. Hierbei sind die große Diffusionskonstante von ZrO₂ für Sauerstoff und das Vermögen, als Sauerstoffreservoir für das HTS-Vormaterial zu dienen, besonders vorteilhaft.

Ein nach einer Abfolge von Verformungs- und Glühschritten zu erhaltendes HTS-Einkernleiterendprodukt geht schematisch aus der Figur der Zeichnung in Querschnittsansicht hervor. Der Einkernleiter ist allgemein mit 2 bezeichnet. Sein Leiterkern 5 aus dem fertigen Hoch-T_{c}-Supraleitermaterial ist in eine Matrix 4 beispielsweise aus Cu oder einer Cu-Legierung eingebettet. Dabei ist die Matrix von dem Material des Leiterkerns durch eine dünne Zwischenschicht 3 z.B. aus mit Yttrium stabilisiertem ZrO₂ getrennt.

Das vorstehend beschriebene Verfahren kann nicht nur zur Herstellung von Einkernleitern dienen, sondern ist ebenso auch zur Herstellung von Mehrkernleitern geeignet. Solche Mehrkern- bzw. Multifilamentleiter werden im allgemeinen mittels einer an sich bekannten Bündelungstechnik ausgebildet. Dementsprechend ist z.B. eine Bündelung von mehreren Leiterzwischenprodukten, die jeweils aus einem Hüllrohr und einem darin befindlichen Kern aus dem umhüllten Vorprodukt bestehen und mindestens einer querschnittsvermindernden Verformungsbehandlung wie z.B. einem kalt-isostatischen Pressen unterzogen sind, in einem größeren Hüllrohr aus dem Matrixmaterial vorzusehen. Selbstverständlich können auch noch weiterverformte und gegebenenfalls vorgeglühte Zwischenprodukte in ein solches Hüllrohr eingebracht werden. Der so erhaltene Rohleiter wird dann in bekannter Weise zu einem draht- oder bandförmigen Leiterendprodukt weiterverarbeitet.

Ein nach entsprechenden Verformungs- und Wärmebehandlungsschritten gewonnenes, bandförmiges Endprodukt eines HTS-Multifilamentleiters hat z.B. 55 Leiterkerne aus dem HTS-Material in einer normalleitenden Matrix aus Cu. Jeder Leiterkern ist dabei von einer dünnen YSZ-Schicht vollständig umschlossen. Jeder Leiterkern hat vorteilhaft ein sogenanntes Aspektverhältnis (= Kernbreite / Kerndicke) zwischen etwa 20 und 80, insbesondere von mindestens 50. Die Kerndicke sollte dabei vorzugsweise höchstens 20 µm betragen und insbesondere unter 15 µm liegen. Entsprechende Multifilamentleiter mit Leiterkernen aus dem Supraleitermaterial (Bi,Pb)₂Sr₂Ca₂Cu₃Oₓ können dann vorteilhaft kritische Stromdichten J_{c} von über 50 kA/cm² (bei 77 K, im Nullfeld) erreichen. Sie sind gegenüber entsprechenden Bandleitern mit Ag-Matrix deutlich kostengünstiger herstellbar.

## Patentansprüche

1. Supraleiter mit mindestens einem in ein normalleitendes, zumindest weitgehend silberfreies Matrixmaterial (4) eingebetteten Leiterkern, welcher ein von einem oxidischen Material umhülltes Supraleitermaterial mit mindestens einer Hoch-T_{c}-Phase auf Basis eines Bi-Cuprates enthält, **dadurch gekennzeichnet, daß** als oxidisches Umhüllungsmaterial (3) um den mindestens einen Leiterkern (5) Zirkonoxid (ZrO₂) oder ein mit Yttrium (Y) teil- oder vollstabilisiertes Zirkonoxid vorgesehen ist.

2. Supraleiter nach Anspruch 1, **gekennzeichnet durch** ein normalleitendes Material einer Matrix (4) aus Kupfer (Cu) oder einem kupferhaltigem Material.

3. Supraleiter nach Anspruch 1 oder 2, **gekennzeichnet durch** mindestens einen Leiterkern (5) aus einem Bi-Cuprat mit einer Bi-2223-Phase zumindest als Hauptbestandteil.

4. Supraleiter nach einem der Ansprüche 1 bis 3, **gekennzeichnet durch** eine Bandform.

5. Supraleiter nach Anspruch 4, **gekennzeichnet durch** ein Aspektverhältnis seines mindestens einen Leiterkerns (5) von wenigstens 20, vorzugsweise wenigstens 50.

6. Supraleiter nach Anspruch 4 oder 5, **gekennzeichnet durch** eine Dicke seines mindestens einen Leiterkerns (5) von höchstens 20 µm, vorzugsweise höchstens 15 µm.

7. Supraleiter nach einem der Ansprüche 4 bis 6, **gekennzeichnet durch** eine kritische Stromdichte bei 77 K von über 50 kA/cm².

8. Verfahren zur Herstellung eines Supraleiters nach einem der Ansprüche 1 bis 7, **dadurch gekennzeichnet, daß**
- ein Vorprodukt des Leiterkerns (5) mit einer Umhüllung (3) aus dem Zirkonoxid-Material erstellt wird,
- das umhüllte Vorprodukt in ein Hüllrohr aus dem normalleitenden Matrixmaterial (4) eingebracht wird und mindestens einer querschnittsvermindernden Verformungsbehandlung unterzogen wird,
- sowie das so erhaltene Zwischenprodukt zu dem Endprodukt des Supraleiters weiterverarbeitet wird.

9. Verfahren nach Anspruch 8, **dadurch gekennzeichnet, daß** das Vorprodukt mit einer Folie aus dem Zirkonoxid-Material vollständig umhüllt wird.

10. Verfahren nach Anspruch 8 oder 9, **dadurch gekennzeichnet, daß** aus dem Zwischenprodukt ein Bündel von entsprechenden einzelnen Zwischenproduktelementen erstellt wird, die in ein Hüllrohr aus dem Matrixmaterial eingebracht werden, und sich die Weiterverarbeitung des Bündels zu dem Endprodukt anschließt.

## Claims

1. Superconductor comprising at least one conductor core embedded in a normal-conducting, at least substantially silver-free matrix material (4) and containing a superconductor material with at least one bismuth cuprate-based high T_{c} phase sheathed in an oxide material, **characterised in that** zirconium oxide (ZrO₂) or a zirconium oxide partially or completely stabilised with yttrium (Y) is provided as the oxide sheathing material (3) around the at least one conductor core (5).

2. Superconductor according to claim 1, **characterised by** a normal-conducting material of a matrix (4) consisting of copper (Cu) or a copper-containing material.

3. Superconductor according to claim 1 or claim 2, **characterised by** at least one conductor core (5) consisting of a bismuth cuprate with a Bi 2223 phase at least as the main constituent.

4. Superconductor according to one of claims 1 to 3, **characterised by** a tape shape.

5. Superconductor according to claim 4, **characterised by** an aspect ratio of its at least one conductor core (5) of at least 20, preferably at least 50.

6. Superconductor according to claim 4 or claim 5, **characterised by** a thickness of its at least one conductor core (5) of no more than 20 µm, preferably no more than 15 µm.

7. Superconductor according to one of claims 4 to 6, **characterised by** a critical current density at 77 K of more than 50 kA/cm².

8. Method for the production of a superconductor according to one of claims 1 to 7, **characterised in that**
- a precursor of the conductor core (5) with a sheath (3) consisting of the zirconium oxide material is prepared,
- the sheathed precursor is introduced into a sheath consisting of the normal-conducting matrix material (4) and is subjected to at least one section-reducing deformation treatment operation,
- and the intermediate product obtained in this manner is further processed to form the final superconductor.

9. Method according to claim 8, **characterised in that** the precursor is sheathed completely in a foil consisting of the zirconium oxide material.

10. Method according to claim 8 or claim 9, **characterised in that** a bundle of corresponding intermediate elements is prepared from the intermediate product and is introduced into a sheath consisting of the matrix material, after which the bundle is further processed to form the end product.

## Revendications

1. Supraconducteur comprenant au moins un filament conducteur noyé dans un matériau de matrice (4), normalement conducteur mais au moins largement sans argent, ce filament contenant un matériau supraconducteur enveloppé par un matériau à base d'oxyde avec au moins une phase à haute T_{c} à base d'un bi-cuprate,
**caractérisé en ce que**
comme matériau de l'enveloppe (3) à base d'oxyde, entourant au moins un filament conducteur (5), il est prévu un oxyde de zirconium (ZrO₂) ou un oxyde de zirconium partiellement ou totalement stabilisé par de l'yttrium (Y).

2. Supraconducteur selon la revendication 1,
**caractérisé en ce que**
le matériau normalement conducteur de la matrice (4) est du cuivre Cu ou un matériau à base de cuivre.

3. Supraconducteur selon la revendication 1 ou 2,
**caractérisé en ce qu'**
au moins un filament conducteur (5) est un bi-cuprate avec une phase Bi - 2223 comme composant principal.

4. Supraconducteur selon les revendications 1 à 3,
**caractérisé en ce qu'**
il a la forme d'un ruban.

5. Supraconducteur selon la revendication 4,
**caractérisé en ce que**
le rapport d'aspect d'au moins un filament conducteur (5) est au moins égal à 20, de préférence supérieur à 50.

6. Supraconducteur selon la revendication 4 ou 5,
**caractérisé en ce que**
l'épaisseur d'au moins un filament conducteur (5) est au plus de 20 microns, de préférence inférieur à 15 microns.

7. Supraconducteur selon les revendications 4 à 6,
**caractérisé en ce que**
sa densité de courant critique à 77 K dépasse 50 kA/cm².

8. Procédé de fabrication d'un supraconducteur selon une des revendications 1 à 7,
**caractérisé en ce qu'**
- un semi-produit du filament conducteur (5) est fabriqué avec une enveloppe (3) en matériau à base d'oxyde de zirconium,
- le semi-produit enveloppé est introduit dans une enveloppe tubulaire constituée du matériau (4) normalement conducteur de matrice et soumis à un traitement de déformation réduisant sa section, et
- le produit intermédiaire ainsi obtenu est façonné pour donner le produit final du supraconducteur.

9. Procédé selon la revendication 8,
**caractérisé en ce que**
le semi-produit est totalement enveloppé dans une feuille de matériau à base d'oxyde de zirconium.

10. Procédé selon la revendication 8 ou 9,
**caractérisé en ce qu'**
à partir du produit intermédiaire, on réalise une botte d'éléments individuels de ce produit, on l'introduit dans une enveloppe tubulaire faite du matériau de la matrice et on procède au façonnage de la botte donnant le produit final.
